# EUROPEAN PATENT APPLICATION

(11) **EP 2 292 473 A1**
(43) Date of publication of application: **09.03.2011**
(21) Application number: 10196322.1
(22) Date of filing: 12.10.2006
(51) Int. Cl.: B60R 16/02, B65D 81/26, F21S 8/10, F21V 31/03, F24F 7/00

(54) **Vent member and vent structure**

(30) Priority: 14.12.2005 JP 2005361092
(62) Divisional of application: 06811704.3
(71) Applicant: Nitto Denko Corporation, Ibaraki-shi Osaka 567-8680 (JP)
(72) Inventor: Furuyama, Satoru, IBARAKI-SHI, OSAKA 567-8680 (JP); Yanagi, Toshiki, IBARAKI-SHI, OSAKA 567-8680 (JP)
(74) Representative: Barbin le Bourhis, Joël

(57) **Abstract**

A vent structure (100A) of the present invention includes a housing (91) and a vent member (13A) attached to an opening portion (91k) of the housing (91). The vent member (13A) is provided with a support body (11) having a through hole (11h) to serve as a gas passage between the interior and the exterior of the housing (91) and a gas permeable membrane (6) fixed to the support body (11) so as to close the through hole (11h). Assuming that a thickness direction of the gas permeable membrane is a height direction, a height (H₁) of the support body (11) from a second opening end face (11q) (aligned with an outer surface (91p) of the housing (91)) to a first opening end face (11p) on the other side is set to 4 mm or more.

## Description

### Technical Field

The present invention relates to a vent member attached to a housing that accommodates automobile components, electronic components or the like. The present invention also relates to a vent structure using the vent member.

### Background Art

Housings that accommodate automobile electrical components such as lamps, sensors and ECUs (electronic control unit) have a vent member attached thereto to ensure ventilation between the interior and the exterior of the housing and to prevent foreign matter from intruding into the housing. One example of such a vent member is disclosed in JP 2004-47425A and JP 2003-336874A.

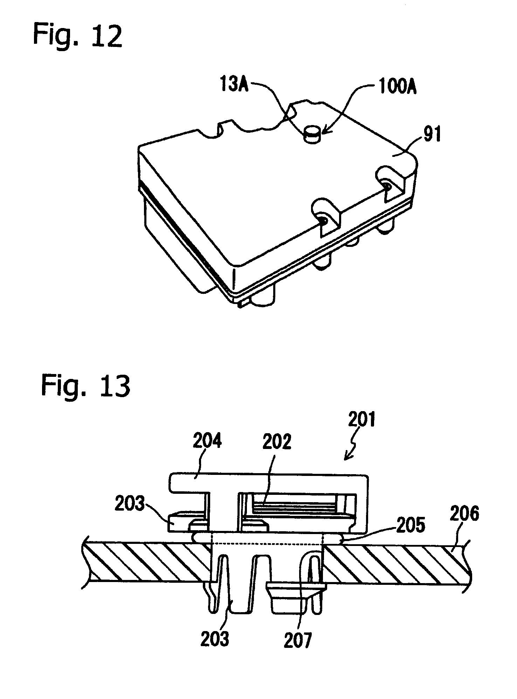

A vent member disclosed in JP 2004-47425A is, for example, provided with a support body 203 on which a gas permeable membrane 202 is disposed and a cover part 204 attached to the support body 203 so as to cover the gas permeable membrane 202, as shown in Fig. 13. The vent member 201 thus configured is fixed to an opening portion 207 of a housing 206 via an O-ring 205. Gas is allowed to permeate through the gas permeable membrane 202 so that ventilation between the interior and the exterior of the housing 206 is ensured. The cover part 204 prevents the gas permeable membrane 202 from being damaged by an external force, and deteriorated in gas permeability due to the deposition of dust.

The vent member shown in Fig. 13 can be attached to the opening portion of the housing with ease. Furthermore, the protrusion from an outer surface of the housing is relatively low. This seems to be preferable because the vent member occupies no excess space. However, intensive studies made by the inventor have found that this is not always the case.

To be more specific, it is assumed that the gas permeable membrane of the vent member is close to the outer surface of the housing when the vent member is attached to the opening portion of the housing. When water droplets or oil droplets adhere to the outer surface of the housing in such a case, the water droplets or the like possibly flow toward a surface of the gas permeable membrane easily along a side surface the support body to which the gas permeable membrane is fixed. This phenomenon becomes obvious when the water droplets or oil droplets remain around a boundary between the vent member and the housing and the atmospheric pressure inside the housing rapidly drops below the atmospheric pressure outside the housing.

### Disclosure of Invention

In view of the foregoing, the present invention has an object to provide a vent member that can prevent water droplets or the like from flowing toward the gas permeable membrane even when the droplets adhere to the outer surface of the housing, and thereby can maintain gas permeability in a reliable manner. The present invention has another object to provide a vent structure using this vent member. The vent member according to the present invention is defined by claim 1 or claim 4.

More specifically, the present disclosure provides a vent member to be attached to a housing that needs ventilation. The vent member includes a support body having a through hole to serve as a gas passage between the interior and the exterior of the housing and a gas permeable membrane fixed to the support body so as to close the through hole. Assuming that a thickness direction of the gas permeable membrane is a height direction, the support body is formed so that the through hole extends in the height direction from one opening end face to the other opening end face, and the height from the one opening end face to the other opening end face is set to 4 mm or more.

Another aspect of the present disclosure also provides a vent member to be attached to a housing that needs ventilation. The vent member includes a support body having a through hole to serve as a gas passage between the interior and the exterior of the housing, and a gas permeable membrane fixed to the support body so as to close the through hole. The support body includes a base portion to be connected to the housing. An area of the base portion defined by an outline of a lateral cross-section perpendicular to the thickness direction of the gas permeable membrane increases continuously or stepwise from the side on which the gas permeable membrane is disposed toward the side that is to be connected to the housing.

Still another aspect of the present disclosure provides a vent member to be attached to a housing that needs ventilation. The vent member includes a support body having an interior space to serve as a gas passage between the interior and the exterior of the housing and an opening portion through which the interior space communicates with the exterior of the housing, and a gas permeable membrane fixed to the support body so as to close the opening portion. Assuming that a thickness direction of the gas permeable membrane is a height direction, one of the end faces of the support body in the height direction serves as a predetermined fixing surface that is to be fixed to the housing directly or via another member, and the height from the predetermined fixing surface to the end face on the other side on which the opening portion is formed is set to 4 mm or more.

Still another aspect of the present disclosure provides a vent structure including a housing that needs ventilation and the above-mentioned vent member attached to an opening portion of the housing.

In the vent member (or the vent structure) of the present disclosure described above, the height from the outer surface of the housing to the opening end face on the opposite side sufficiently is ensured as 4 mm or more. This makes it possible to prevent water droplets or the like from flowing onto the gas permeable membrane even when water droplets or the like remain in areas including a connection point between the vent member and the housing. In other words, it is possible to obtain a vent member that can maintain gas permeability in a reliable manner even when water droplets or the like adhere to the outer surface of the housing.

In the vent member (or the vent structure) of another aspect of the present disclosure, the support body, to which the gas permeable membrane is fixed, includes the base portion having a lateral cross-sectional area increasing continuously or stepwise toward the housing. According to such a structure, it becomes difficult for water droplets or the like to remain around the border between the vent member and the housing. As a result, it is possible to obtain a vent member that can prevent water droplets or the like from flowing onto the gas permeable membrane even when the water droplets or the like adhere to the outer surface of the housing, and thereby can maintain gas permeability in a reliable manner.

### Brief Description of Drawings

Fig. 1A is a perspective view of a vent member of a first embodiment.
Fig. 1B is a sectional perspective view of the vent member of Fig. 1A.
Fig. 2A is a sectional perspective view of a modification of the vent member of Fig. 1A.
Fig. 2B is a sectional perspective view of another modification of the vent member shown of Fig. 1A.
Fig. 3A is a perspective view of a vent member of a second embodiment.
Fig. 3B is a sectional perspective view of the vent member of Fig. 3A.
Fig. 4A is a sectional perspective view of a vent member of a third embodiment.
Fig. 4B is a sectional perspective view of a modification of the vent member of Fig. 4A.
Fig. 5A is a perspective view of a vent member of a fourth embodiment.
Fig. 5B is a sectional perspective view of the vent member of Fig. 5A.
Fig. 5C is a sectional perspective view of the modification of the vent member of Fig. 5A.
Fig. 5D is a sectional perspective view of another modification of the vent member shown in Fig. 5A.
Fig. 6A is a perspective view of a vent member of a fifth embodiment.
Fig. 6B is a sectional perspective view of the vent member of Fig. 6A.
Fig. 6C is a view explaining operation of the vent member of Fig. 6A.
Fig. 6D is a view explaining operation of a conventional vent member.
Fig. 7A is a perspective view of a vent member of a sixth embodiment.
Fig. 7B is a sectional perspective view of the vent member of Fig. 7A.
Fig. 8A is a perspective view of a modification of the vent member shown in Fig. 7A.
Fig. 8B is a sectional perspective view of the vent member of Fig. 8A.
Fig. 8C is a perspective view of another modification of the vent member shown in Fig. 7A.
Fig. 8D is a sectional perspective view of the vent member of Fig. 8C.
Fig. 8E is a sectional perspective view of a further modification of the vent member shown in Fig. 7A.
Fig. 9A is a perspective view of a vent member of a seventh embodiment.
Fig. 9B is a sectional perspective view of the vent member of Fig. 9A.
Fig. 10A is a perspective view of a vent member of an eighth embodiment.
Fig. 10B is a sectional perspective view of the vent member of Fig. 10A.
Fig. 11 is a perspective view of a vent member of a ninth embodiment.
Fig. 12 is a general view of a housing on which a vent member is attached.
Fig. 13 is a side view of a conventional vent member.

### Best Mode for Carrying Out the Invention

### (First Embodiment)

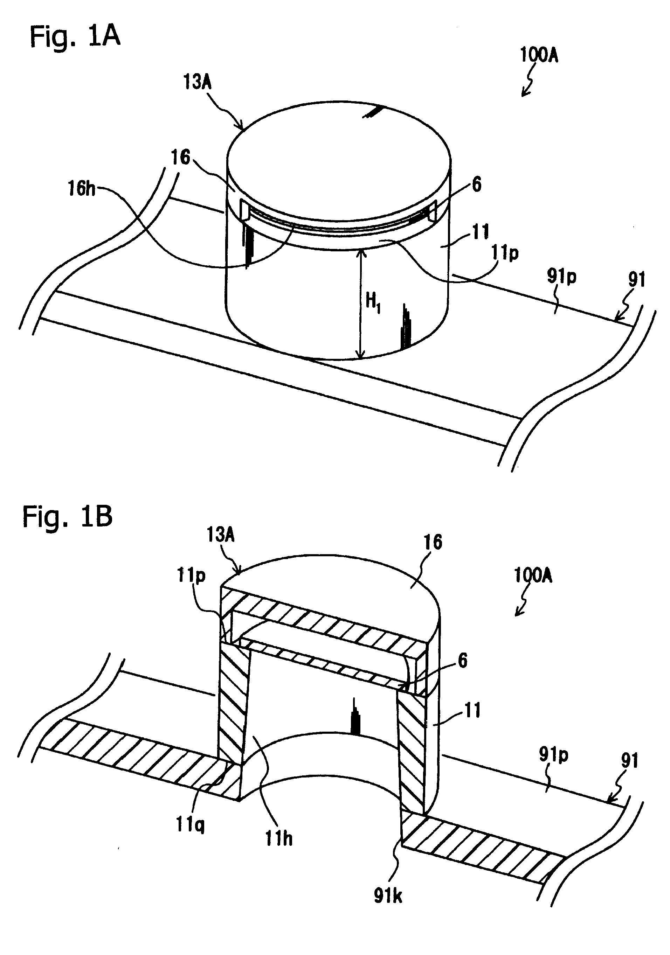

Hereinafter, embodiments of the present invention will be described with reference to the attached drawings. Fig. 1A is a perspective view of a vent member of a first embodiment, and Fig. 1B is a sectional perspective view thereof. Fig. 12 is a general view of a housing on which the vent member of Fig. 1A is attached. As shown in Fig. 12, the vent member 13A shown in Fig. 1A and 1B constitutes a vent structure 100A for providing ventilation between the interior and the exterior of a housing 91 when attached to an opening portion 91k of the housing 91 of, for example, an automobile electrical component. The housing is not limited to a box-shaped housing as shown in Fig. 12. Any components or articles having an interior space that needs ventilation can be a housing to which the vent member of the present invention is to be attached.

As shown in Fig. 1A and 1B, the vent member 13A is provided with a support body 11 having a through hole 11h to serve as a gas passage between the interior and the exterior of the housing 91 and a gas permeable membrane 6 disposed on the support body 11 so as to close one of the openings of the through hole 11h. The support body 11 is of an approximately circular cylindrical shape. The gas permeable membrane 6 of a circular shape is disposed on a first opening end face 11p, which is one of the opening end faces of the circular cylindrical support body 11. A diameter of the gas permeable membrane 6 is smaller than an outer diameter of the support body 11 and larger than an inner diameter of the support body 11 at the first opening end face 11p. The vent member 13A is fixed to the opening portion 91k of the housing 91 in such a manner that the through hole 11h of the support body 11, the gas permeable membrane 6 and the opening portion 91k of the housing 91 are arranged concentrically. That is, one of the openings of the through hole 11 formed in the support body 11 is closed by the gas permeable membrane 6 while the other opening opens toward the interior of the housing 91. The gas permeable membrane 6 allows a gas to permeate therethrough and prevents entry of foreign matter, such as water droplets and dust. The gas permeability of the gas permeable membrane 6 maintains the pressure inside of the housing 91 equal to the pressure outside of the housing.

The support body 11 of the vent member 13A includes a cover 16 forming a clearance between the gas permeable membrane 6 and itself and covering the gas permeable membrane 6 on the side opposite to the side that is to be attached to the opening portion 91k of the housing 91. In short, of the first opening end face 11p and a second opening end face 11q, which are the two opening end faces of the support body 11, the first opening end face 11p located on the opposite side of the second opening end face 11q is covered with the cover 16. The clearance is formed between the first opening end face 11p and the cover 16, and it communicates with an opening 16h that opens in a direction parallel to an in-plane of the gas permeable membrane 6. Such a structure protects the gas permeable membrane 6 from water droplets and dust and ensures ventilation between the interior and the exterior of the housing 91 through the gas permeable membrane 6. It should be noted that in this embodiment, the cover 16 is manufactured as a separate part from the support body 11 having the through hole 11h. The cover 16 is combined with the support body 11 after the gas permeable membrane 6 is fixed on the first opening end face 11p.

The support body 11 as described above can be manufactured by popular molding techniques, such as injection molding, compression molding, and cutting. From the viewpoint of moldability, a thermoplastic resin is preferably used as a material for the support body 11. Specifically, thermoplastic resins such as PBT (polybutylene terephthalate), PA (nylon) and PET (polyethlene terephthalate), and thermoplastic elastomers such as EPDM (ethylene propylene rubber) and silicone rubber can be used. The materials for the support body 11 may include pigments such as carbon black and titanium white, reinforcement fillers such as glass particles and glass fibers, and water repellants. The support body 11 repels liquid (such as water and oil) more easily when applied with a liquid-repellent treatment on its surface. Other treatments for providing desired characteristics such as adhesiveness improvement, electrical insulation, semiconductivity, conductivity may be applied on the support body 11.

On the other hand, the gas permeable membrane 6 is not particularly limited in terms of structure and material as long as it is a membrane that allows gas permeation while preventing liquid permeation. This embodiment describes the gas permeable membrane 6 formed by laminating a reinforcing layer on a resin porous membrane. More specifically, this embodiment describes the gas permeable membrane 6 with three layers (for example, TEMISH (registered trademark) available from Nitto Denko Corp.) formed by laminating a resin porous membrane on top and bottom of a reinforcing layer. With the reinforcing layer, the gas permeable membrane 6 is allowed to have a higher strength.

As a material for the resin porous membrane, a fluororesin porous body and a polyolefin porous body that can be manufactured by a known drawing method or extracting method can be used. Examples of the fluororesin include PTFE (polytetrafluoroethylene), polychlorotrifluoroethylene, tetrafluoroethylene-hexafluoropropylene copolymer, and tetrafluoroethylene-ethylene copolymer. Examples of the monomer of which the polyolefin is composed include ethylene, propylene and 4-methylpentene-1,1 butene. It is possible to use a polyolefin obtained by polymerizing these monomers independently or copolymerizing them. A nanofiber film porous body or the like using polyacrylonitrile, nylon and polylactate also can be used. In particular, a PTFE porous body is preferably used because it can ensure gas permeability even with a small area and prevent foreign matter from intruding into the housing in a highly effective manner.

The liquid-repellent treatment may be applied to the resin porous membrane that forms the gas permeable membrane 6 in accordance with the application of the housing. The liquid-repellent treatment can be carried out by applying the resin porous membrane with a substance having small surface tension, drying the substance and then curing the substance. A liquid-repellent agent used for the liquid-repellent treatment is not particularly limited as long as it can form a coating having a surface tension lower than that of the resin porous membrane. For example, a liquid-repellent agent containing polymers having perfluoroalkyl groups is suitable. The liquid-repellent agent may be applied by impregnation, spraying or the like. From the viewpoint of ensuring sufficient waterproofness, the average pore diameter of the resin porous membrane is preferably 0.01 µm or more and not more than 10 µm.

It is preferable that the material of the reinforcing layer forming the gas permeable membrane 6 excels more in gas permeability than the resin porous membrane. Specifically, a fabric, a nonwoven fabric, a mesh, a net, a sponge, a form, a porous body (Sunmap available from Nitto Denko Corp., for example) or the like can be used. These are made of resin or metal. Examples of the methods for bonding the resin porous membrane to the reinforcing layer include adhesive lamination, heat lamination, heat welding, laser welding, ultrasonic welding, and the use of an adhesive agent.

The thickness of the gas permeable membrane 6 is set in the range of, for example, 1 µm to 5 mm, taking into account its strength and the ease of fixing to the support body 11. The gas permeability of the gas permeable membrane 6 is preferably in a rage of 0.1 to 300 sec/100 cm³ in terms of Gurley value. Although the gas permeable membrane 6 is fixed to the support body 11 by heat welding in this embodiment, the gas permeable membrane 6 may be fixed to the support body 11 by other methods such as ultrasonic welding and the use of an adhesive agent.

Descriptions made herein regarding the support body and the gas permeable membrane apply to other embodiments to be described later.

A thickness direction of the gas permeable membrane 6 is assumed as a height direction in the descriptions hereinafter including other embodiments. It is also assumed that the surface of the gas permeable membrane 6 facing to the side of the housing 91 is an under surface while the surface on the opposite side is an upper surface.

As shown in Fig. 1A and 1B, an outer surface 91p of the housing 91 surrounding the vent member 13A is a flat surface approximately parallel to a principal surface of the gas permeable membrane 6 in this embodiment. As shown in Fig. 1B, the second opening end face 11q on the opposite side of the first opening end face 11p to which the gas 6 is fixed is a bonding surface that is directly bonded to the opening portion 91k of the housing 91. The through hole 11h is formed so as to extend almost linearly in the height direction from the second opening end face 11q to the first opening end face 11p.

In the support body 11, a height H₁ from the second opening end face 11q to the gas permeable membrane 6, in other words, a height H₁ from the outer surface 91p of the housing 91 surrounding the vent member 13A to the gas permeable membrane 6, is set to 4 mm or more. When thus configured, it is possible to prevent the water droplets or the like adhering to the outer surface 91p of the housing 91 from flowing onto the gas permeable membrane 6 in a highly effective manner. The height H₁ of 4 mm or more makes it difficult for the water droplets or the like adhering to the housing 91 to reach the gas permeable membrane 6 under normal conditions. The height H₁ is set preferably to 6 mm or more, further preferably to 10 mm or more, in order to prevent the water droplets or the like from contacting the gas permeable membrane 6 in a more reliable manner. It is desirable, however, that the height H₁ is 30 mm or less in order to avoid an excessive protrusion of the vent member 13A from the outer surface 91p of the housing 91. These dimensions apply to other embodiments to be described later.

A method such as heat welding, ultrasonic welding, laser welding, the use of an adhesive tape, the use of an adhesive agent can be adopted for fixing the vent member 13A to the opening portion 91k of the housing 91. In the vent member 13A shown in Fig. 1A and 1B, the height H₁ of the support body 11 from the outer surface 91p of the housing 91 to the under surface of the gas permeable membrane 6 is set to be smaller than the outer diameter of the support body 11 in a cross section perpendicular to the height direction. This makes it possible to obtain a sufficient stability when the vent member 13A is fixed to the opening portion 91k of the housing 91, and thereby reduce the possibility that the vent member 13A falls off the housing 91 when an impact is applied thereto by foreign matter or the like.

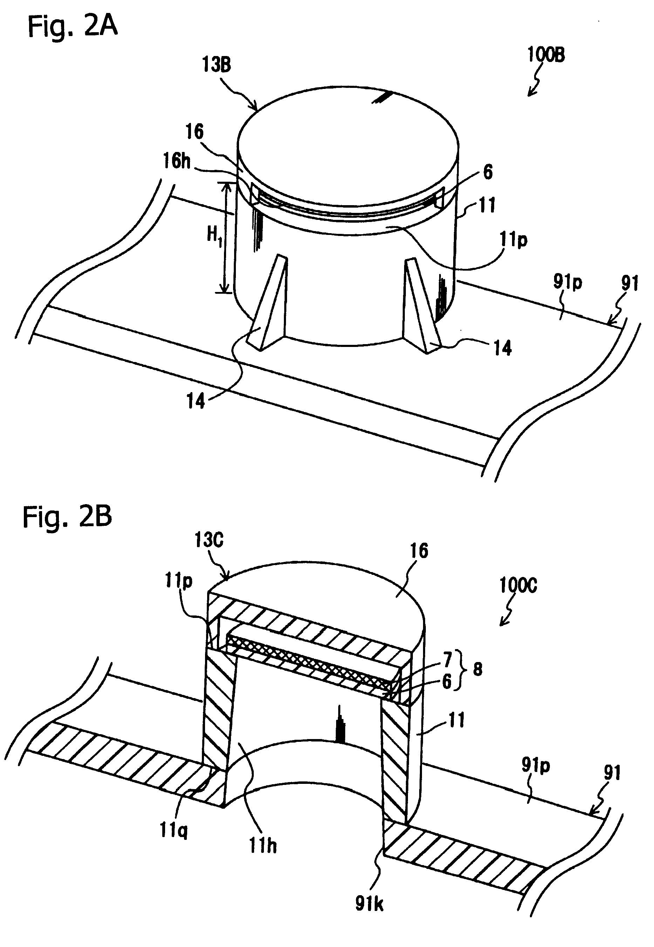

Ribs 14, 14 protruding outward in a radial direction may be provided at plural points in a circumferential direction on the side of the second opening end face 11q, like a vent member 13B shown in Fig. 2A. The ribs 14, 14 are bonded to the outer surface 91p of the housing 91. According to a vent structure 100B in which the vent member 13B is attached to the opening portion 91k of the housing 91, the bonding strength between the vent member 13B and the housing 91 can be increased with ease. The ribs 14, 14 configured in this manner can be adopted in any embodiments to be described later.

Incidentally, the vent member of the present invention is, in some cases, available for so-called insert molding. In the insert molding, the vent member is inserted to a mold for molding the housing so as to be integrated with the resin of which the housing will be composed. According to such an insert molding method, good productivity is achieved because it can omit the step of attaching the vent member to the housing. However, there may be a possibility that a rate of occurrence of defective products rises in exchange for the reduced number of production steps. This is because when the insert molding is being carried out, a high atmospheric pressure is applied to the gas permeable membrane of the vent member, causing the gas permeable membrane to fall off the support body or to be broken in some cases. In order to deal with this problem, the improvement below is effective.

That is, like a vent member 13C included in a vent structure 100C shown in Fig. 2B, a gas permeable membrane 8 can be used that includes a main membrane body 6 formed of the resin porous membrane and a gas-permeable reinforcement member 7 attached to the main membrane body 6 so as to cover at least one of the principal surfaces of the main membrane body 6. The main membrane body 6 is reinforced by the reinforcement member 7. When configured in this manner, it is possible to prevent or suppress occurrence of failures, such as separation and breakage of the main membrane body 6 during the housing 91 is being molded. The main membrane body 6 is exactly the gas permeable membrane shown in Fig. 1A and 1B, as can be understood from the fact that the same reference numeral is given to each of them.

The reinforcement member 7 is required to have characteristics that can ensure the gas permeability of the main membrane body 6 and excel more at preventing separation and breakage than the main membrane body 6. Hence, it is preferable that the reinforcement member 7 includes a mesh made of metal or resin. It is more preferable that the reinforcement member 7 is formed of a mesh. It is preferable that the main membrane body 6 and the reinforcement member 7 are bonded by heat welding or the use of an adhesive agent to be integrated together. It is also preferable that the reinforcement member 7 is composed of a resin having substantially the same composition as that of the resin of which the support body is composed. This allows the support body 11 and the reinforcement member 7 to be bonded together more tightly by a welding method, such as heat welding, ultrasonic welding and laser welding. The metal or resin mesh may be formed of woven metal wires or woven resin wires, a sheet perforated with many holes like a known punching metal, and a molded body manufactured by a known molding method using a mold, and further, a grid-like material having a high rigidity. In the example of Fig. 2B, the reinforcement member 7 is bonded only to one side of the main membrane body 6, but it may be disposed on both sides of the main membrane body 6. The term "substantially the same composition" referred to herein is not intended to exclude the case where an inevitable impurity is contained, and the case where a slight difference exists that has no significant effect on the characteristics.

In the vent member described in this and other embodiments, the support body may be dividable into an upper portion and a lower portion in the area other than the cover. Furthermore, a vent member provided with a support body having no cover and the gas permeable membrane exposed upward may be adopted.

### (Second Embodiment)

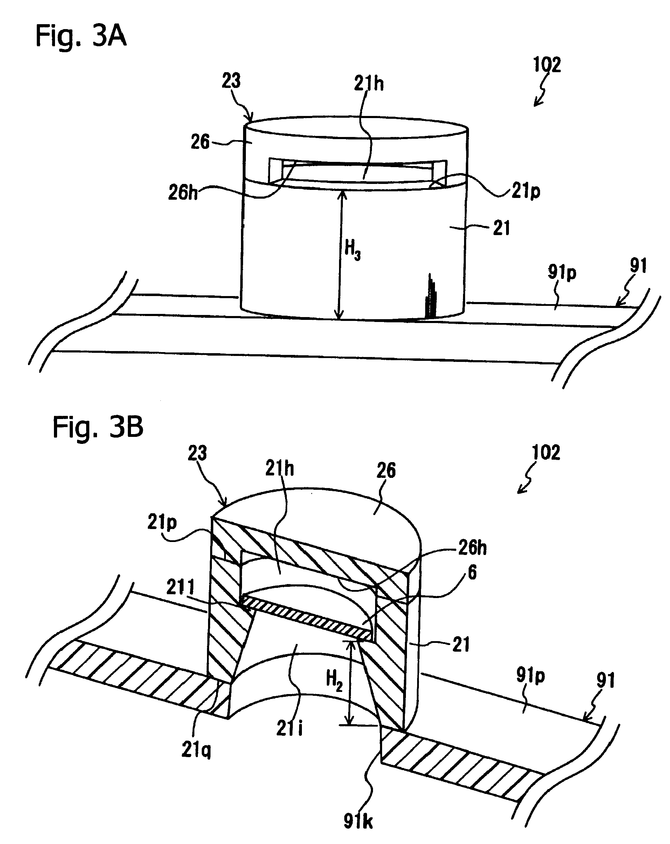

Fig. 3A is a perspective view of a vent member of a second embodiment, and Fig. 3B is a sectional perspective view thereof. A vent structure 102 for performing ventilation between the interior and the exterior of the housing 91 is constituted by attaching a vent member 23 shown in Fig. 3A and 3B to the opening portion 91k of the housing 91.

The vent member 23 is provided with a support body 21 having a through hole 21h and 21i to serve as a gas passage between the interior and exterior of the housing 91 and the gas permeable membrane 6 fixed to the support body 21 so as to close the through hole 21h and 21i. A second opening end face 21q serves as a bonding surface that is directly bonded to the housing 91. The support body 21 includes a cover 26 covering the gas permeable membrane 6. A clearance between the gas permeable membrane 6 and the cover 26 communicates with an opening 26h that opens in a direction parallel to the in-plane of the gas permeable membrane 6. The vent member 23 shares these points with the vent member 13 of the first embodiment.

On the other hand, a first opening end face 21p located on the farther side from the housing 91 serves as an end face to which the cover 26 is fixed. The gas permeable membrane 6 is not disposed on the first opening end face 21p. In this embodiment, the gas permeable membrane 6 is disposed in the through hole 21h and 21i. The through hole 21h and 21i is formed of a first portion 21h that is outside of the housing 91 and a second portion 21i that is inside of the housing 91, and divided by the gas permeable membrane 6. When the gas permeable membrane 6 is disposed in the through hole 21h and 21i in such a manner, a height H₃ of the support body 21 from the second opening end face 21q (an end face aligned with the outer surface 91p of the housing 91) to the first opening end face 21p on the opposite side may be set to 4 mm or more. When configured in this manner, it is possible to prevent highly effectively the water droplets or the like adhering to the outer surface 91p of the housing 91 from flowing over the support body 21 and intruding into the through hole 21h.

More preferably, a height H₂ of the support body 21 from the second opening end face 21q to the under surface of the gas permeable membrane 6 is 4 mm or more. When configured in this manner, it is possible to obtain a sufficient length for the through hole 21i which is inside of the housing 91. The through hole 21i with an adequate length is advantageous in that it can prevent water droplets from immediately adhering to the gas permeable membrane 6 even when moisture condensation occurs in the housing 91 because the water droplets slowly flows inside of the through hole 21i. This is also preferable because the height H₃ from the outer surface 91p of the housing 91 to the first opening end face 21p naturally becomes 4 mm or more when the height H₂ from the outer surface 91p of the housing 91 to the gas permeable membrane 6 is set to 4 mm or more.

The support body 21 includes a stepped portion 211 formed along an entire circumference inside the through hole 21h and 21i. A cross-sectional area of the through hole 21h and 21i with respect to a lateral direction perpendicular to the height direction changes discontinuously at the stepped portion. In other words, the stepped portion 211 includes the boundary between the first portion 21h and the second portion 21i of the through hole 21h and 21i. The gas permeable membrane 6 is disposed on this stepped portion 211. According to this structure, the gas permeable membrane 6 can be disposed in the through hole 21h and 21i easily and reliably. By disposing the gas permeable membrane 6 in the through hole 21h and 21i, it is possible to protect the gas permeable membrane 6 from water droplets and dust that come flying from the lateral direction. In this embodiment, the diameter of the through hole 21h, which is outside of the housing 91, is set to be larger than the diameter of the gas permeable membrane 6. The gas permeable membrane 6 is inserted from the through hole 21h to be fixed to the stepped portion 211. When configured in this manner, the gas permeable membrane 6 can be fixed to the stepped portion 211 with ease.

A reinforced gas permeable membrane 8 (see Fig. 2B) may be used instead of the gas permeable membrane 6. In this case, the gas permeable membrane 8 is fixed to the support body 21 so that the reinforcement member 7 or the main membrane body 6 is in contact with a seating face of the stepped portion 211.

### (Third Embodiment)

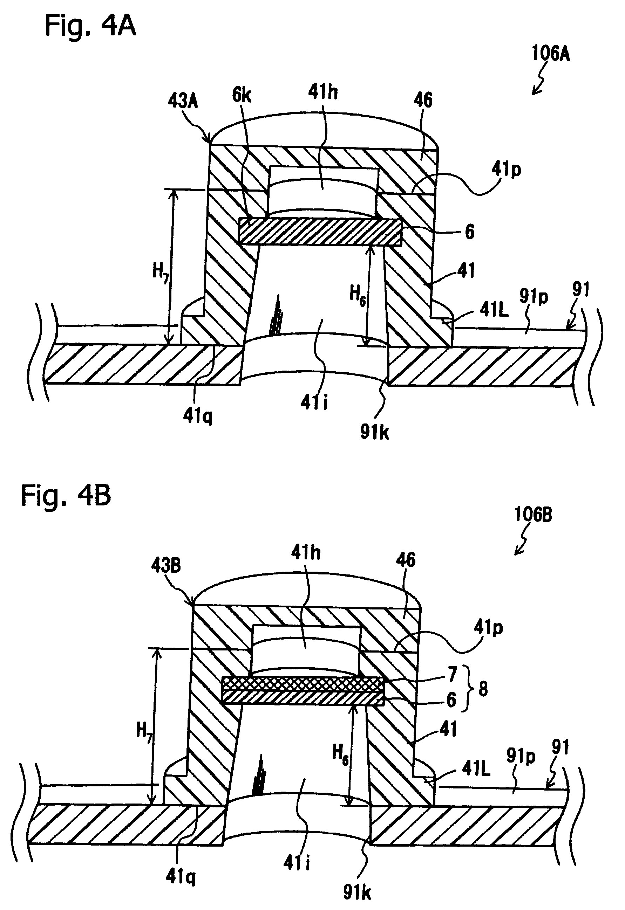

A vent member 43A of a third embodiment shown in Fig. 4A is a modification of the vent member 23 of the second embodiment. A vent structure 106A is constituted by attaching the vent member 43A to the opening portion 91k of the housing 91. This embodiment is common with the embodiments above in that a through hole 41h and 41i is divided into an upper portion and a lower portion by the gas permeable membrane 6, a support body 41 includes a cover 46, and a height H₇ from the outer surface 91p of the housing 91 to a first opening end face 41p is set to 4 mm or more. A difference is that the gas permeable membrane 6 is integrated with the support body 41 by insert molding.

As shown in Fig. 4A, the gas permeable membrane 6 is fixed to the support body 41 in the through hole 41h and 41i by integrating a peripheral portion 6k with the resin of which the support body 41 is composed. In other words, the peripheral portion 6k of the gas permeable membrane 6 is embedded into the support body 41. When configured in this manner, the gas permeable membrane 6 can be fixed to the support body 41 more tightly. Should the vent member 43A be exposed to a strong water stream, the gas permeable membrane 6 will not fall off the support body 41. It is preferable also in this embodiment that the support body 41 of the vent member 43A has a height H₆ of 4 mm or more from the outer surface 91p (aligned with a second opening end face 41q) of the housing 91 to the gas permeable membrane 6.

In the vent member 43A of this embodiment, the outer diameter of an opening portion 41L on the side that is bonded to the housing 91 is larger than the outer diameter of the opening portion on the opposite side. According to the support body 41 with the opening portion 41L, the area of the bonding surface 41q is increased, and thereby the bonding strength between the vent member 43A and the housing 91 is enhanced. It goes without saying that the opening portion 41L can be adopted to an vent member of other embodiments.

Like a vent member 43B included in a vent structure 106B shown in Fig. 4B, it is also possible to use the gas permeable membrane 8 including the main membrane body 6 and the reinforcement member 7. In this case, the peripheral portion of the main membrane body 6 and that of the reinforcement member 7 are both embedded into the support body 41. The gas permeable membrane 8 can be fixed to the support body 41 more tightly with the combination of the reinforcing effect of the reinforcement member 7 and the effect of being embedded into the support body 41.

### (Fourth Embodiment)

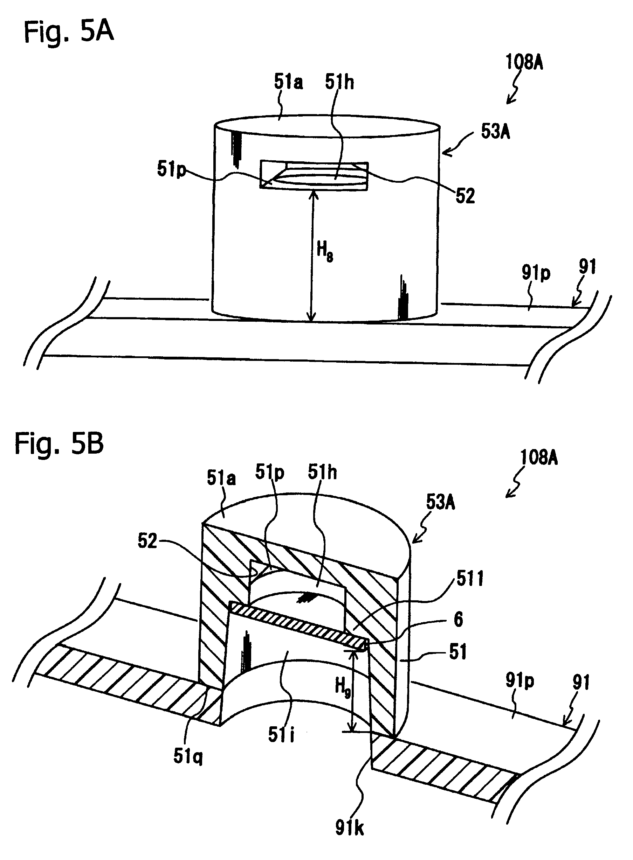

Fig. 5A is a perspective view of a vent member of a fourth embodiment, and Fig. 5B is a sectional perspective view thereof. A vent member 53A shown in Fig. 5A and Fig. 5B is a modification of the second embodiment. The gas permeable membrane 6 is disposed in a through hole 51h and 51i of a support body 51, the support body 51 includes a cover 51a, and a height H₈ from the outer surface 91p of the housing 91 to a first opening end face 51p is set to 4 mm or more. These points are common with the vent member 23 and the vent structure 102 shown in Fig. 3A and 3B. It is also common in that a second opening end face 51q of the support body 51 serves as a bonding surface to the housing 91, and a vent structure 108A is constituted by attaching the vent member 53A to the opening portion 91k of the housing 91.

As shown in Fig. 5B, the support body 51 includes a stepped portion 511 formed along an entire circumference inside the through hole 51h and 51i. A cross-sectional area of the through hole 51h and 51i with respect to a lateral direction perpendicular to the height direction changes discontinuously at the stepped portion 511. In other words, the stepped portion 511 includes the boundary between a first portion 51h and a second portion 51i of the through hole 51h and 51i. The gas permeable membrane 6 is disposed on this stepped portion 511. It should be noted that in the vent member 53A, of the through hole 51h and 51i of the support body 51, the through hole 51h exposed to outside of the housing 91 has a smaller diameter than the through hole 51i that is inside of the housing 91. The gas permeable membrane 6 is inserted into the through hole 51i from the side of the second opening end face 51q connected to the opening portion 91k of the housing 91, and then disposed on the stepped portion 511.

According to the vent member 53A, a cross-sectional area of the through hole 51h and 51i with respect to a lateral direction discontinuously becomes smaller at the stepped portion 511 from the side attached to the housing 91 toward the opposite side. Therefore, the gas permeable membrane 6 is pressed onto a seating face of the stepped portion 511 when an air pressure is applied in a direction from the housing 91 side to the opposite side. Hence, it is possible to reduce a rate of occurrence of separation and breakage of the gas permeable membrane 6 during the housing 91 with the vent member 53A is being manufactured by insert molding.

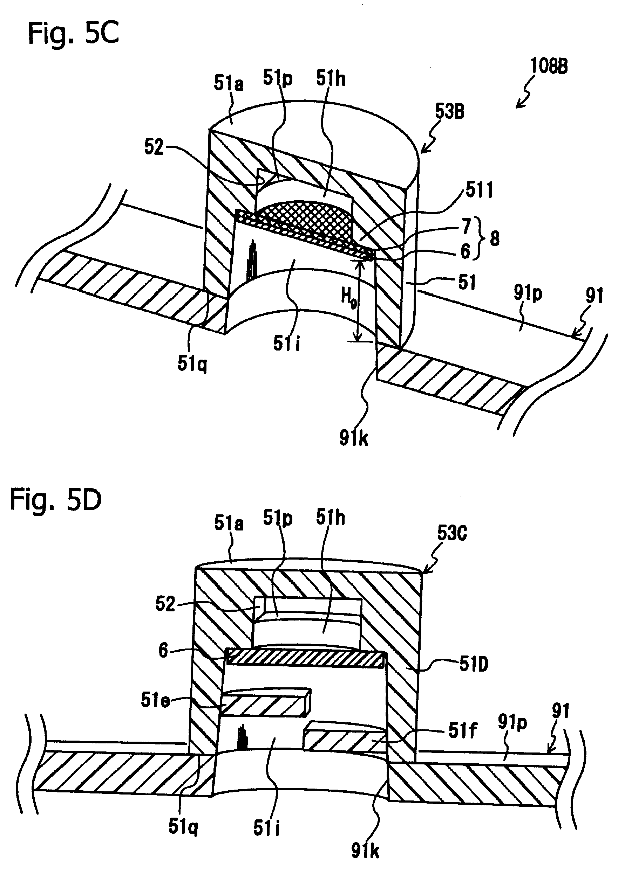

More preferably, the gas permeable membrane 8 reinforced with the reinforcement member 7 is used like a vent member 53B included in a vent structure 108B shown in Fig. 5C. In this case, the gas permeable membrane 8 is fixed to the support body 51 so that the reinforcement member 7 is in contact with the seating face of the stepped portion 511. According to the vent member 53B, the main membrane body 6 is pressed onto the reinforcement member 7 when an air pressure is applied in a direction from the side of the housing 91 to the opposite side. The reinforcement member 7 preferably includes a mesh made of metal or resin, or a porous body (Sunmap available from NITTO DENKO Corp., for example) and has a rigidity higher than that of the main membrane body 6. The reinforcement member 7 thus configured has low possibilities of breakage and separation from the support body 51 due to an air pressure applied during the insert molding, and thereby firmly supports the main membrane body 6 at all times. As described above, it is preferable that the reinforcement member 7 is composed of a resin having substantially the same composition as that of the resin of which the support body 51 is composed.

It is preferable in this embodiment as well that the support body 51 of the vent member 53A and 53B has a height H₉ of 4 mm or more from the outer surface 91p of the housing 91 to the gas permeable membrane 6.

Furthermore, in this embodiment, the cover 51a of the support body 51 is integrally manufactured by injection molding with a body part in which the through hole 51h and 51i is formed. It should be noted, however, that there is no change in that a clearance between the gas permeable membrane 6 and the cover 51a communicates with an opening 52 that opens in a direction parallel to the in-plane of the gas permeable membrane 6.

A vent member 53D shown in Fig. 5D also is suitable. A support body 51D of the vent member 53D includes baffles 51e and 51f that are disposed in the way of a gas passage running from the gas permeable membrane 6 to the housing 91 and prevent gas or liquid from traveling straight with respect to the height direction in the through hole 51i. By disposing these baffles 51e and 51f in the through hole 51i, it is possible to prevent water droplets from flowing directly to the gas permeable membrane 6 even when moisture condensation occurs in the housing 91. When configured in this manner, it is possible to ensure the gas permeability of the gas permeable membrane 6 at all times and eliminate the moisture condensation in the housing 91 smoothly. These baffles 51e and 51f can be adopted in any other embodiment.

### (Fifth Embodiment)

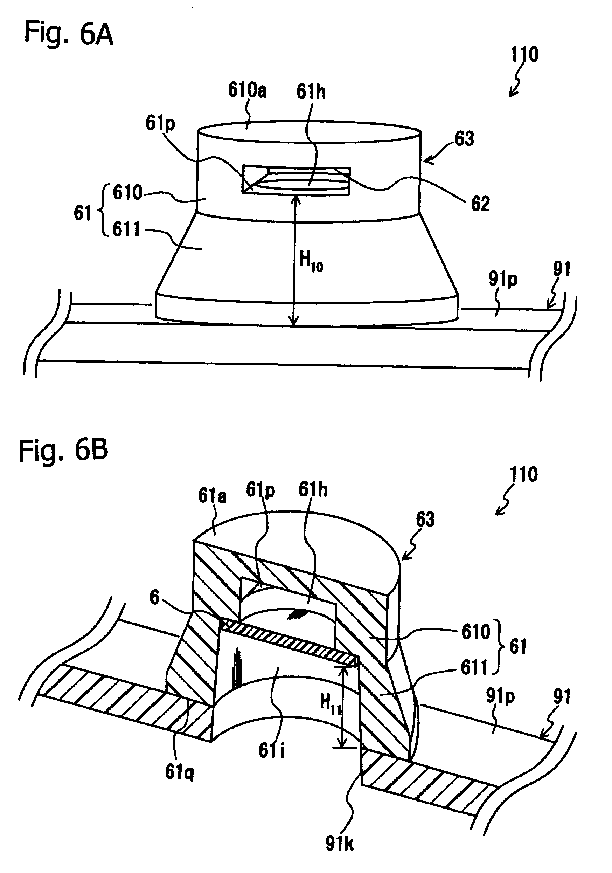

A support body 61 of a vent member 63 shown in Fig. 6A and 6B includes a base portion 611 to be connected to the housing 91. An area of the base portion 611 defined by an outline of a lateral cross-section perpendicular to the thickness direction of the gas permeable membrane 6 increases continuously or stepwise from the side on which the gas permeable membrane 6 is disposed toward the side that is to be connected to the housing 91. The base portion 611 of the support body 61 is fixed to the opening portion 91k of the housing 91. The upper portion (opposite side to the housing) adjacent to the base portion 611 is a fixed-diameter portion 610 having a fixed outer diameter. A cover 61a covering the gas permeable membrane 6 is included in the fixed-diameter portion 610. A clearance between the gas permeable membrane 6 and the cover 61a communicates with an opening 62 that opens in a direction parallel to the in-plane of the gas permeable membrane 6. A vent structure 110 is constituted by attaching the vent member 63 to the opening portion 91k of the housing 91. The base portion 611 of the support body 61 prevents the water droplets or the like adhering to the outer surface 91p of the housing 91 from accumulating around the vent member 63.

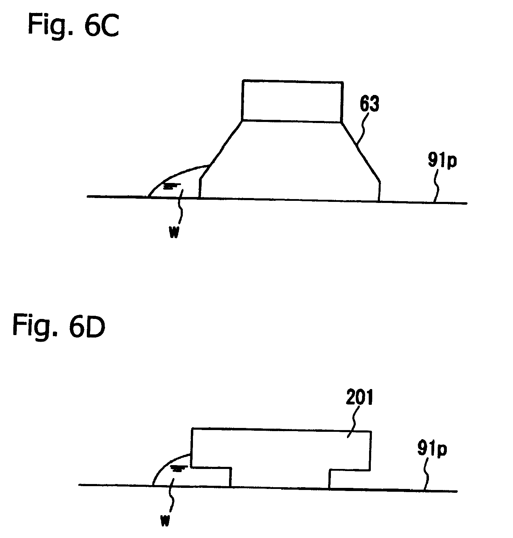

Fig. 6C is a view explaining operation of a vent member of this embodiment and Fig. 6D is that of a conventional vent member. First, as shown in Fig. 6C, according to the vent member 63 of this embodiment having a sloping side surface so as to be wider toward the housing 91, a water droplet W has to increase its surface area in order to accumulate between the vent member 63 and the outer surface 91p of the housing 91, and thus becomes unstable. Thereby the water droplet W smoothly is removed from the area around the vent member 63. On the other hand, as shown in Fig. 6D, a conventional vent member 201 has a side surface rising perpendicularly. This allows the water droplet W to have a smaller surface area and become stable when accumulating between the vent member 201 and the outer surface 91p of the housing 91. As a result, the water droplet W tends to stay around the vent member 201 and flow onto the gas permeable membrane 6 more easily. Especially, this becomes obvious with the conventional vent member 201 (Fig. 13) whose height to the gas permeable membrane is insufficient.

As shown in Figs. 6A and 6B, in the vent member 63, the above-mentioned cross-sectional outline of the base portion is approximately circular, and a diameter of the base portion increases continuously. Through hole 61h and 61i is formed so as to extend in the height direction from an end face 61q on the larger-diameter side to an opening end face 61p on the smaller-diameter side of the base portion 611. The gas permeable membrane 6 is disposed in the through hole 61h and 61i. The base portion 611 having the circular cross-section even more effectively prevents water droplets or the like from accumulating around the vent member 63.

Furthermore, it is preferable that a height H₁₀ from the end face 61q (a second opening end face 61q aligned with the outer surface 91p of the housing 91) on the large-diameter side to the opening end face 61p (a first opening end face 61p) on the small-diameter side is set to 4 mm or more. More preferably, a height H₁₁ from the end face 61q on the larger-diameter side of the base portion 611 to the gas permeable membrane 6 is set to 4 mm or more as in the embodiments above. When configured in this manner, it is possible to prevent the water droplets or the like adhering to the outer surface 91p of the housing 91 from flowing toward the gas permeable membrane 6, and thereby the vent structure 110 with excellent waterproofness can be obtained.

In the embodiment of Figs. 6A and 6B, the base portion 611 has an outer diameter increasing continuously toward the side of the housing 91. However, it is possible to provide a base portion whose outer diameter increases stepwise. The structure with a sloping side surface may be applied to other embodiments. For example, the vent member can be of a very simple structure by removing the cover 61a and disposing the gas permeable membrane 6 on the opening end face 61p. The reinforced gas permeable membrane 8 (see Fig. 5C) can be suitably adopted instead of the gas permeable membrane 6.

### (Sixth Embodiment)

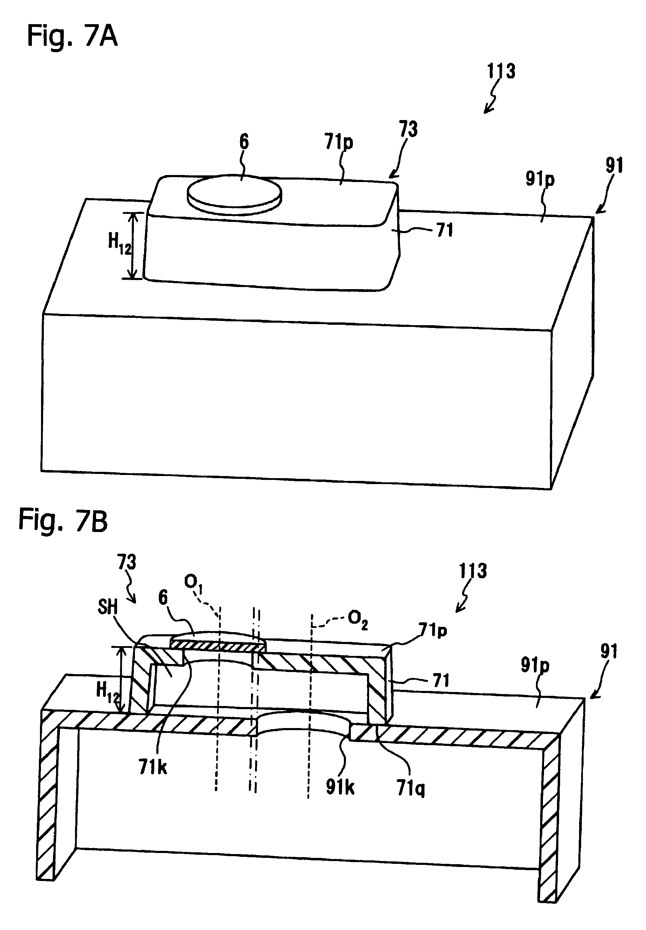

A vent member 73 shown in Figs. 7A and 7B is provided with a box-shaped support body 71 and the gas permeable membrane 6 fixed to the support body 71 so as to close an opening portion 71k of the box-shaped support body 71. The box-shaped support body 71 has an interior space SH to serve as a gas passage between the interior and the exterior of the housing 91 and the opening portion 71k through which the interior space SH communicates with the exterior of the support body 71. Assuming that a thickness direction of the gas permeable membrane 6 is a height direction, one end face 71q of the support body 71 in the height direction serves as a bonding surface 71q directly bonded to the housing 91. The vent member 73 is fixed directly to the housing 91 so that the opening portion 91k of the housing 91 is exposed to the interior space SH of the support body 71. In the support body 71, a height H₁₂ from the bonding surface 71q to an end face 71p in which the opening portion 71k is formed is set to 4 mm or more. When configured in this manner, it is possible to prevent the water droplets or the like adhering to the outer surface 91p of the housing 91 from flowing onto the gas permeable membrane 6.

In the vent member 73 of this embodiment, the opening portion 91k of the housing 91 and the gas permeable membrane 6 are arranged in a staggered positional relationship in an in-plane direction (lateral direction) perpendicular to the height direction. To be more specific, a central axis O₁ of the circular gas permeable membrane 6 and a central axis O₂ of the opening portion 91k (also circular) of the housing 91 are not aligned. In a projection view in the height direction, the opening portion 71k of the support body 71 and the opening portion 91k of the housing 91 are arranged so as to avoid overlapping each other in the in-plane. According to such a positional relationship, the interior space SH of the vent member 73 increases in the in-plane direction, making even more difficult for the water droplets or the like to reach the gas permeable membrane 6.

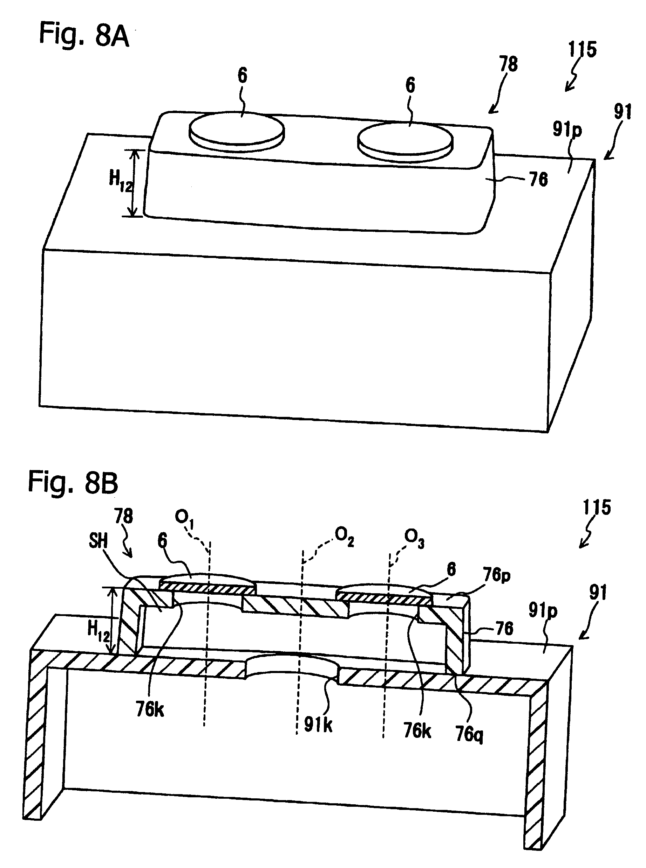

As shown in Figs. 8A and 8B, it is possible to adopt a vent member 78 that includes a support body 76 having plural openings 76k, 76k and plural gas permeable membranes 6, 6 fixed to the support body 76 so as to close each of these openings 76k, 76k. A vent structure 115 is constituted by fixing the vent member 78 to the housing 91 in such an arrangement that the opening portion 91k of the housing 91 is located almost in the middle between the opening portions 76k, 76k that are adjacent to each other on the support body 76. The central axes O₁ and O₃ of the gas permeable membranes 6, 6 are not aligned with the central axis O₂ of the opening portion 91k of the housing 91. According to the vent structure 115, the ventilation level inside the housing 91 is extremely high.

An end face 76q, which is on the opposite side of an end face 76p on which the gas permeable membranes 6 and 6 are disposed, serves as a bonding surface that is in contact with the outer surface 91p of the housing 91. The height H₁₂ from the outer surface 91p of the housing 91 to the end face 76p in which opening portions 76k, 76k are formed is 4 mm or more as in the embodiments described so far. This prevents the water droplets or the like adhering to the outer surface 91p of the housing 91 from flowing onto the gas permeable membranes 6, 6.

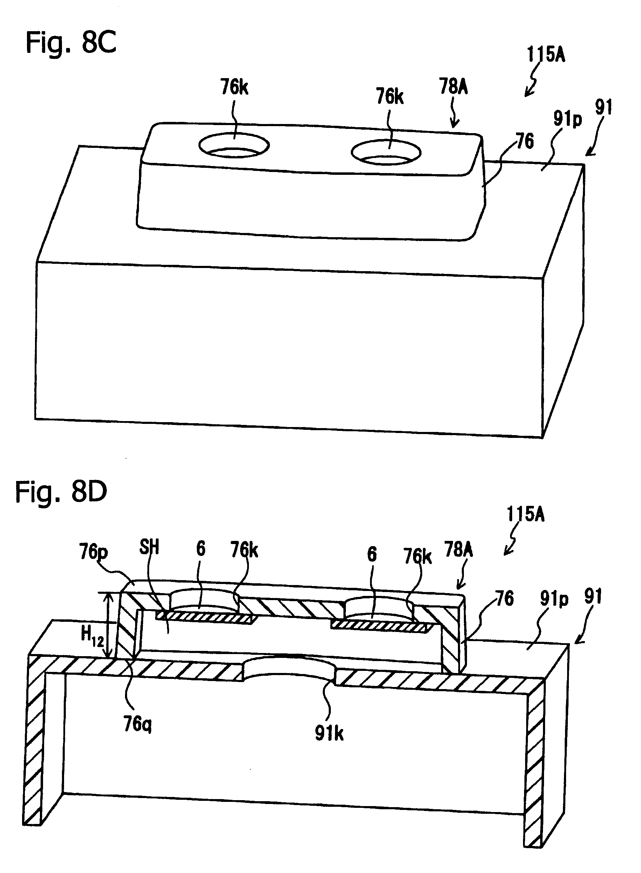

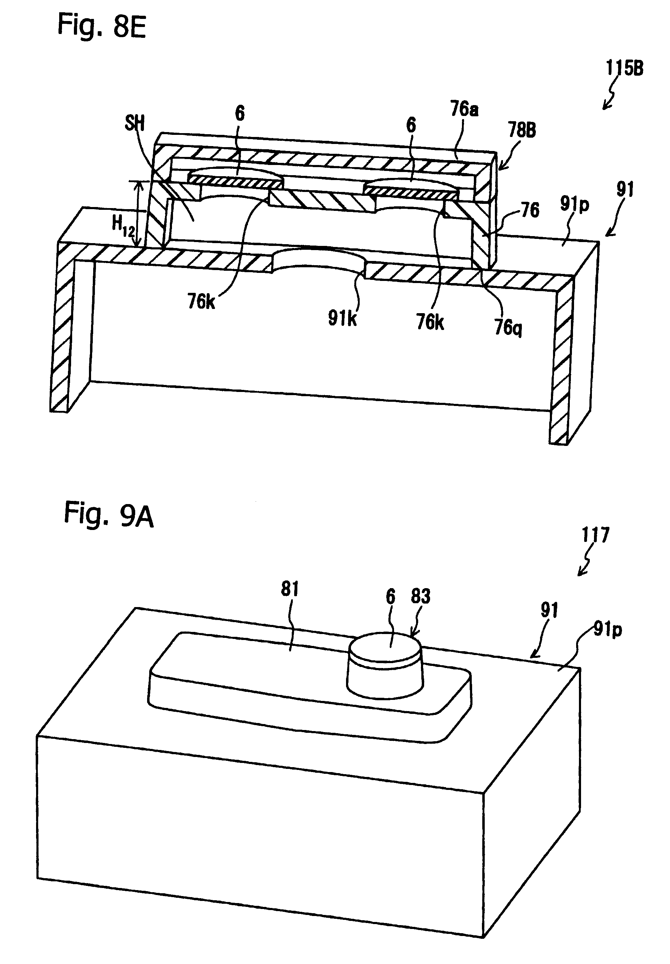

The gas permeable membranes 6, 6 closing the opening portions 76k, 76k may be disposed from the side of the interior space SH of the box-shaped support body 76 like a vent member 78A and a vent structure 115A shown in Figs. 8C and 8D. In a vent structure 115B shown in Fig. 8E, a vent member 78B with a cover 76a covering the gas permeable membranes 6, 6 is adopted. The vent member 78B is provided with the cover 76a forming a clearance between itself and the gas permeable membranes 6, 6 while covering the gas permeable membranes 6, 6 on the side opposite to the side that is attached to the housing 91. The cover 76a can protect the gas permeable membranes 6, 6 from a strong water stream and dust in a reliable manner. Since the cover 76a opens in a direction parallel to the in-plane of the gas permeable membrane 6, there is no fear that the gas permeability of the gas permeable membrane 6 will be decreased.

### (Seventh Embodiment)

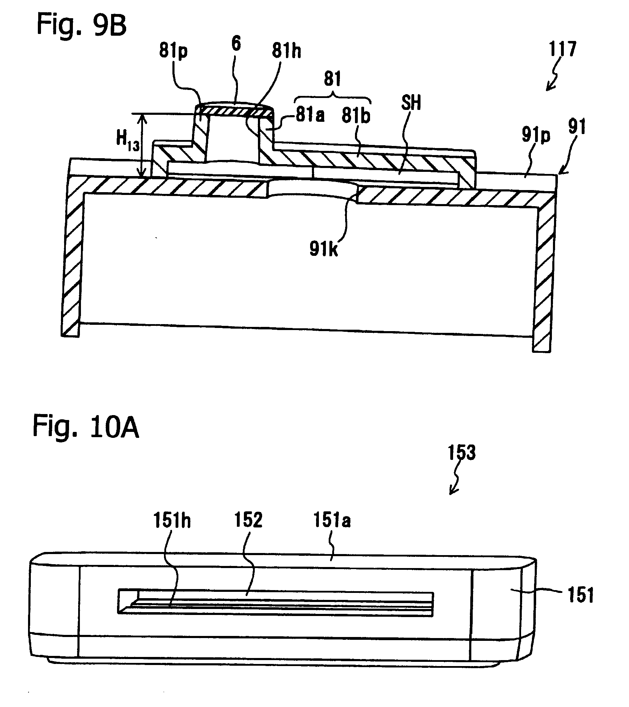

A vent structure 117 shown in Figs. 9A and 9B adopts a vent member 83 including upper faces of different heights. To be more specific, a support body 81 of the vent member 83 is formed of a tubular portion 81a on which the gas permeable membrane 6 is disposed and a box-shaped portion 81b having the interior space SH that communicates with the tubular portion 81a. The tubular portion 81a has a through hole 81h to serve as a gas passage. The gas permeable membrane 6 is disposed on an opening end face 81p of the tubular portion 81a, and closes the through hole 81h from the side opposite to the side adjacent to the box-shaped portion 81b. A height H₁₃ from the outer surface 91p of the housing 91 to the gas permeable membrane is 4 mm or more as in the embodiments above. Furthermore, the tubular portion 81a and the box-shaped portion 81b jointly form a stepped shape. This configuration makes it difficult for the water drops or the like adhering to the outer surface 91p of the housing 91 to flow toward the gas permeable membrane 6. When the space allowed for placing the vent structure 117 is partially insufficient, the vent member 83 having different heights at different points like this embodiment may be adopted. In short, the tubular portion 81a with the gas permeable membrane 6 is located in an area where a sufficient space can be taken while the box-shaped portion 81b with a reduced height is located in an area where there is no sufficient space.

### (Eighth Embodiment)

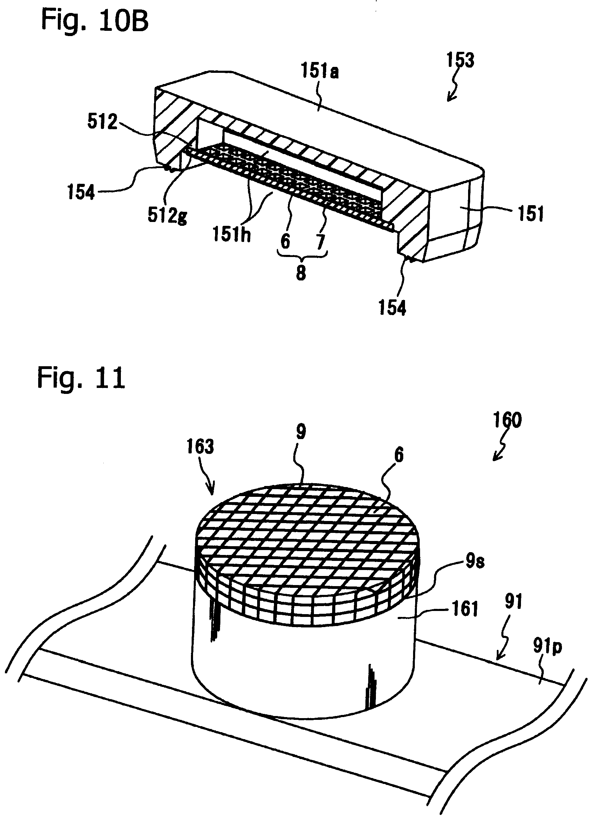

Major features of a vent member 153 shown in Fig. 10A and 10B are common with those of the vent member 53B shown in Fig. 5C, although the shape is different. That is, a support body 151 of the vent member 153 is provided with a through hole 151h to serve as a gas passage having a noncircular (rectangular in this embodiment) cross section. The support body 151 includes a stepped portion 512 on which a gas permeable membrane 8 is disposed and a cover 151a that prevents the through hole 151h from directly being exposed upward. The through hole 151h communicates with an opening 152 that opens in a lateral direction. The stepped portion 512 of the support body 151 is provided with a countersink 512g for fitting the gas permeable membrane 8 (specifically the portion of the reinforcement member 7), and thereby the gas permeable membrane 8 easily can be located with respect to the support body 151. According to the vent member 153 of this embodiment, material waste can be minimized by adopting the rectangular gas permeable membrane 8.

The support body 151 of the vent member 153 includes a rib 154 for ultrasonic welding. Friction generated by a ultrasonic wave is concentrated on the rib 154 and melt it quickly for bonding the vent member 153 to the housing. Thereby the time needed for the bonding process can be shortened. The rib 154 may be provided to the support bodies of other embodiments.

### (Ninth Embodiment)

A problem such as separation and breakage of the gas permeable membrane during the insert molding also can be prevented by a vent member 163 included in a vent structure 160 shown in Fig. 11. The vent member 163 is provided with the gas permeable membrane 6, a circular cylindrical support body 161 on one of whose opening end faces the gas permeable membrane 6 is disposed, and a reinforcement member 9 with a peripheral portion 9s fixed to the support body 161 so as to sandwich the gas permeable membrane 6 between the support body 161 and itself. The peripheral portion 9s of the reinforcement member 9 extends outward beyond the opening end face of the support body 161 on the side on which the gas permeable membrane 6 is disposed. The peripheral portion 9s turns around to a side surface of the support body 161 and is fixed to the support body 161. When configured in this manner, it is possible to prevent the gas permeable membrane 6 from breaking and separating from the support body 161 even if a high air pressure is applied thereto from the housing 91 side.

Like the reinforcement member 7 described in the embodiments above, the reinforcement member 9 preferably includes a porous body or a mesh, and more preferably, the reinforcement member 9 consists of a mesh made of metal or resin. Furthermore, it is preferable that the reinforcement member 9 has flexibility so that the peripheral portion 9s can fit along the side surface of the support body 161 with ease, and accordingly the reinforcement member 9 can be fixed to the support body 161 in a reliable manner. For example, a mesh made of resin is suitable as the reinforcement member 9 because it has excellent flexibility and strength. The reinforcement member 9 may or may not be bonded directly to the gas permeable membrane 6. In other words, the reinforcement member 9 simply may be placed on the gas permeable membrane 6. The method of fixing the peripheral portion 9s of the reinforcement member 9 to the support body 161 is not particularly limited. A method such as welding, the use of an adhesive agent, an adhesive tape or the like can be adopted.

It should be noted that some of the embodiments described above may be used in combination without departing from the technical scope of the present invention.

### Industrial Applicability

A vent member of the present invention is suitable for housings of autoparts, such as lamps, motors, sensors, switches, ECUs, and gearboxes. Especially, the vent member of the present invention exhibits remarkable effect when it is attached to a housing that easily causes moisture condensation inside, directly is exposed to a rainstorm, or receives water streams during car washing. The vent member of the present invention also can be suitably attached to housings of electric appliances, such as mobile communication devices, cameras, electric shavers, and electric toothbrushes, besides autoparts.

## Claims

1. A vent member (13A) to be attached to a housing (91) that needs ventilation, comprising:
a support body (11) having a through hole (11h) to serve as a gas passage between the interior and the exterior of the housing (91); and
a gas permeable membrane (6) fixed to the support body (11) so as to close the through hole (11h), **characterized in that**:
assuming that a thickness direction of the gas permeable membrane (6) is a height direction,
the support body (11) is formed so that the through hole (11h) extends in the height direction from one opening end face (11p) to the other opening end face (11q)
the height from the one opening end face (11p) to the other opening end face (11q) is set to 4 mm or more,
the other opening end face (11q) is formed as a bonding surface for fixing the vent member (13A) to the opening portion of the housing (91) by welding,
the gas permeable membrane (6) is disposed in the through hole (11h),
the peripheral portion of the gas permeable membrane (6) is embedded into the support body (11) inside the through hole (11h) and
the gas permeable membrane (6) is fixed to the support body (11) by having its own peripheral portion (6k) integrated with the resin of which the support body (11) is composed.

2. The vent member according to Claim 1, wherein:
the gas permeable membrane (8) includes a main membrane body (6) including a resin porous membrane and a gas-permeable reinforcement member (7) attached to the main membrane body (6) so as to cover at least one of the principal surfaces of the main membrane body (6), and
a peripheral portion (6k) of the main membrane body (6) and that of the reinforcement member (7) are both embedded into the support body (11).

3. The vent member according to Claim 2, wherein the reinforcement member (7) includes a mesh made of metal or resin.

4. A vent member (13A) to be attached to a housing (91) that needs ventilation, comprising:
a support body (11) having a through hole (11h) to serve as a gas passage between the interior and the exterior of the housing (91);
a gas permeable membrane (6) fixed to the support body (11) so as to close the through hole (11h), and
a reinforcement member (9) whose peripheral portion (9s) is fixed to the support body (11) so as to sandwich the gas permeable membrane (6) between the support body (11) and itself, **characterized in that**:
assuming that a thickness direction of the gas permeable membrane (6) is a height direction,
the support body (11) is formed so that the through hole (11h) extends in the height direction from one opening end face (11p) to the other opening end face (11q),
the height from the one opening end face (11p) to the other opening end face (11q) is set to 4 mm or more,
the reinforcement member (9) consists of a mesh made of metal or resin with flexibility, and
the peripheral portion (9s) of the reinforcement member (9) extends outward beyond the opening end face of the support body (11) on the side on which the gas permeable membrane (6) is disposed, then turns around to a side surface of the support body (11) and is fixed to the support body (11).

5. The vent member according to according to any one of Claims 1 to 4, wherein the height from the other opening end face (11q) to the gas permeable membrane (6) is set to 4 mm or more and 30 mm or less.

6. The vent member according to Claim 5, wherein the height from the other opening end face (11q) is set to 6 mm or more, preferably to 10 mm or more.

7. The vent member according to any one of Claims 1 to 6, wherein the area of the other opening end face (11q) as the bonding surface is larger than that of the one opening end face (11p).

8. A vent structure (100A), comprising:
a housing (91) that needs ventilation; and
a vent member, according to any one of Claims 1 to 7, attached to an opening portion (91k) of the housing (91) by welding.
